# EUROPÄISCHE PATENTSCHRIFT

(11) **EP 3 172 166 B1**
(45) Veröffentlichungstag und Bekanntmachung des Hinweises auf die Patenterteilung: **31.01.2024**
(21) Anmeldenummer: 15732624.0
(22) Anmeldetag: 24.06.2015
(51) Int. Cl.: C01B 32/174, C01B 32/159

(54) **VERFAHREN ZUM WACHSTUM VON VERTIKAL AUSGERICHTETEN EINWANDIGEN KOHLENSTOFFNANORÖHREN MIT GLEICHEN ELEKTRONISCHEN EIGENSCHAFTEN SOWIE ZUM VERVIELFÄLTIGEN VON EINWANDIGEN KOHLENSTOFFNANORÖHREN MIT GLEICHEN ELEKTRONISCHEN EIGENSCHAFTEN**
METHOD FOR GROWING VERTICALLY ORIENTED SINGLE-WALLED CARBON NANOTUBES WITH THE SAME ELECTRONIC PROPERTIES AND FOR REPRODUCING SINGLE-WALLED CARBON NANOTUBES WITH THE SAME ELECTRONIC PROPERTIES
PROCÉDÉ POUR LA CROISSANCE DE NANOTUBES DE CARBONE MONOPAROI, ORIENTÉS VERTICALEMENT, À PROPRIÉTÉS ÉLECTRONIQUES IDENTIQUES, ET POUR LA MULTIPLICATION DE NANOTUBES DE CARBONE MONOPAROI, À PROPRIÉTÉS ÉLECTRONIQUES IDENTIQUES

(30) Priorität: 24.06.2014 DE 102014212077
(43) Veröffentlichungstag der Anmeldung: 31.05.2017
(73) Patentinhaber: SmartNanotubes Technologies GmbH, 01705 Freital (DE)
(72) Erfinder: BEZUGLY, Viktor, 01187 Dresden (DE); BEZUGLY, Eugenia, 01187 Dresden (DE); KHAVRUS, Vyacheslav, 01189 Dresden (DE); KRYLOV, Denis, 01705 Freital (DE); CUNIBERTI, Gianaurelio, 01309 Dresden (DE)
(74) Vertreter: Pfenning, Meinig & Partner mbB
(86) Internationale Anmeldenummer: PCT/EP2015/064311
(87) Internationale Veröffentlichungsnummer: WO 2015/197729

(56) Entgegenhaltungen:
- WO-A2-2005/085132
- WO-A2-2006/117196
- FRANCESCO LAMBERTI ET AL: "Nanotubes Oxidation Temperature Controls the Height of Single-Walled Carbon Nanotube Forests on Gold Micropatterned Thin Layers", LANGMUIR, Bd. 26, Nr. 13, 6. Juli 2010 (2010-07-06), Seiten 11344-11348, XP055208503, ISSN: 0743-7463, DOI: 10.1021/la100708q

## Beschreibung

Die vorliegende Erfindung betrifft ein Verfahren zum Wachstum von vertikal ausgerichteten einwandigen Kohlenstoffnanoröhren mit gleichen elektronischen Eigenschaften sowie zum Vervielfältigen von einwandigen Kohlenstoffnanoröhren mit gleichen elektronischen Eigenschaften.

Kohlenstoffnanoröhren sind aufgrund ihrer speziellen Eigenschaften vielversprechende Kandidaten für zukünftige technische Anwendungen. So können Kohlenstoffnanoröhren in Abhängigkeit von ihrem Durchmesser und ihrer Helizität bzw. Chiralität metallisch oder halbleitend sein. Herstellungsmethoden aus dem Stand der Technik führen allerdings zu einer Mischung von Kohlenstoffnanoröhren unterschiedlicher Typen, also mehrwandige, einwandige, metallische und halbleitende Kohlenstoffnanoröhren in einem Bündel, die nachfolgend mühsam voneinander getrennt werden müssen. Es ist somit bislang nicht möglich, den Durchmesser und die Chiralität der hergestellten Kohlenstoffnanoröhren gezielt während der Herstellung festzulegen.

Bisher wurden einwandige Kohlenstoffnanoröhren durch Bogenentladung, Laserablation sowie katalysatorunterstützte Zersetzung von Kohlenwasserstoffen durch chemische Gasphasenabscheidung (chemical vapor deposition, CVD) erhalten. Diesen Methoden ist jedoch gemein, dass eine Kontrolle der elektronischen Eigenschaften bzw. des Durchmessers und der Chiralität während eines Herstellungsprozesses nicht kontrolliert werden kann.

WO 2006/117196 A2 offenbart ein Verfahren zum Herstellen von Kohlenstoffnanoröhren definierter Chiralität, bei dem ursprünglich vorhandene Kohlenstoffnanoröhren gebrochen und ihre Rümpfe zum Wachsen neuer Röhren verwendet werden.

Aus dem Artikel "Nanotubes Oxidation Temperature Controls the Height of Single-Walled Carbon Nanotubes Forests on Gold Micropatterned Thin Layers", Franceso Lombardi et al., Langmuir, vol. 26, no. 13, 11244-11348, ist ein weiteres Verfahren zum kontrollierten Herstellen von Kohlenstoffnanoröhren bestimmter Länge bekannt.

Der vorliegenden Erfindung liegt daher die Aufgabe zugrunde, ein Verfahren zum Vervielfältigen von Kohlenstoffnanoröhren sowie entsprechende Kohlenstoffnanoröhren zu entwickeln, mit denen die genannten Nachteile vermieden werden, also Kohlenstoffnanoröhren mit gleichen elektronischen Eigenschaften hergestellt werden können.

Diese Aufgabe wird erfindungsgemäß gelöst durch ein Verfahren nach Anspruch 1 sowie einen Träger mit darauf angeordneten Kohlenstoffnanoröhren nach Anspruch 12. Vorteilhafte Ausgestaltungen und Weiterbildungen sind in den abhängigen Ansprüchen beschrieben.

Die Erfindung ist im beigefügten Anspruchssatz beschrieben und betrifft insbesondere ein Verfahren zum Vervielfältigen von mindestens einer einwandigen Kohlenstoffnanoröhre oder mehreren einwandigen Kohlenstoffnanoröhren mit gleichen elektronischen Eigenschaften weist mehrere Schritte auf. Zunächst wird eine Dispersion aus einer Flüssigkeit und der mindestens einen einwandigen Kohlenstoffnanoröhre oder den mehreren einwandigen Kohlenstoffnanoröhren hergestellt, die gleiche elektronische Eigenschaften haben. Durch einen Energieeintrag in die Dispersion werden Fragmente der mindestens einen einwandigen Kohlenstoffnanoröhre oder der mehreren einwandigen Kohlenstoffnanoröhren ausgebildet, diese Kohlenstoffnanoröhren also gebrochen. Aus der Dispersion werden die erzeugten Fragmente auf eine Oberfläche eines Trägers aufgebracht und dienen nach dem Aufbringen als Startschicht zum Vervielfältigen. Gleichzeitig hierzu, also während des Aufbringens aus der Dispersion, insbesondere solange die Dispersion in ihrer flüssigen Phase vorliegt und noch nicht getrocknet ist, werden die Fragmente auf der Oberfläche ausgerichtet, so dass die Oberfläche von einer Längsachse der Fragmente geschnitten wird und die Fragmente nicht parallel in einer Ebene zu dem Träger bzw. genauer zu der genannten Oberfläche des Trägers ausgerichtet sind, wobei die Fragmente durch Selbstorganisation auf einer auf der Oberfläche des Trägers aufgebrachten Goldschicht ausgerichtet werden oder auf der Oberfläche des Trägers auf eine aus einem in der Dispersion enthaltenen Tensid gebildete Tensidschicht mit einer Dicke, die geringer ist als eine Länge der Fragmente, aufgebracht werden, auf der die Fragmente der mindestens einen einwandigen Kohlenstoffnanoröhre nach dem Trocknen der Tensidschicht aufgebracht und ausgerichtet sind, sowie auf dem Träger durch die Tensidschischt fixiert werden. Der Träger mit den darauf aufgebrachten und ausgerichteten Fragmenten wird anschließend in eine Vorrichtung zur chemischen Gasphasenabscheidung eingebracht. Durch chemische Gasphasenabscheidung werden in der Vorrichtung zur chemischen Gasphasenabscheidung einwandige Kohlenstoffnanoröhren mit gleichen elektronischen Eigenschaften ausgehend von den als Startschicht dienenden Fragmenten in einer kohlenstoffhaltigen Gasatmosphäre gewachsen, indem die Fragmente verlängert werden.

Durch das beschriebene Verfahren können Kohlenstoffnanoröhren mit definierten, vorgegebenen Eigenschaften erzeugt werden und ein nachfolgendes Sortieren entfällt. Dadurch, dass bereits eine homogene Mehrzahl von Kohlenstoffnanoröhren verwendet wird und diese vervielfältigt werden, werden Kohlenstoffnanoröhren mit gleichen elektronischen und vorzugsweise gleichen optischen Eigenschaften erzeugt. Die eine einwandige Kohlenstoffnanoröhre oder die mehreren einwandigen Kohlenstoffnanoröhren, die als Ausgangsstoff für das Verfahren verwendet werden, können hierbei sowohl metallisch als auch halbleitend sein. Durch das Ausrichten auf der Oberfläche können die Kohlenstoffnanoröhren in einer Richtung einfach verlängert werden, ohne sich gegenseitig zu behindern, so dass sich idealerweise vertikal zu der Oberfläche und parallel zueinander angeordnete einwandige Kohlenstoffnanoröhren auf dem Träger ausbilden und sich eine hohe Packungsdichte an Kohlenstoffnanoröhren je Flächeneinheit ergibt. Da dieses Ausrichten auf der Oberfläche gleichzeitig zu dem Aufbringen erfolgt, wird das Verfahren effizienter durchführbar und eine Dichte der Anordnung von Kohlenstoffnanoröhren auf dem Substrat wird erhöht. Die Längsachse eines der Fragmente soll hierbei die Achse bezeichnen, um die das jeweilige Fragment der Kohlenstoffnanoröhren rotationssymmetrisch angeordnet ist. Das Verfahren weist außerdem den Vorteil auf, dass typischerweise keine Katalysatoren wie bei herkömmlichen Herstellungsverfahren verwendet werden müssen und somit die Kohlenstoffnanoröhren besonders rein vorliegen, es kann aber natürlich auch vorgesehen sein, bei der chemischen Gasphasenabscheidung Katalysatoren zu verwenden. Die Längsachsen der Kohlenstoffnanoröhren liegen nach dem Durchführen des Verfahrens typischerweise unter einem von 0° verschiedenen Winkel zu einer parallel zu der Oberfläche des Trägers liegenden Ebene.

Die Kohlenstoffnanoröhren, mit denen das Verfahren gestartet werden kann, können auch nur zu einem bestimmten Prozentsatz, typischerweise 80 Prozent, vorzugsweise 90 Prozent, besonders vorzugsweise 99 Prozent einwandige Nanoröhrchen mit gleichen elektronischen Eigenschaften, also metallisch oder halbleitend, und bzw. oder einem jeweils gleichen Durchmesser und bzw. oder einer jeweils gleichen Chiralität umfassen. Das Verfahren ist bei einem höheren Anteil an Kohlenstoffnanoröhren mit gleichen Eigenschaften besser durchzuführen, ein geringer Anteil an Kohlenstoffnanoröhren mit zumindest einer abweichenden Eigenschaft kann jedoch toleriert werden. Die Kohlenstoffnanoröhren mit gleichen Eigenschaften, die als Ausgangsmaterial des Verfahrens dienen, sind typischerweise mit einem aus dem Stand der Technik bekannten Verfahren hergestellt und durch bekannte Separationsverfahren, z. B. Ultrazentrifugation, Chromatografie oder auf Gelen oder Polymeren basierende Verfahren, hinsichtlich ihrer Eigenschaften sortiert worden.

Es kann vorgesehen sein, dass die Fragmente in der Dispersion durch ein Einbringen von Ultraschall ausgebildet werden. Ultraschall sorgt für eine zuverlässige Teilung bzw. ein Durchschneiden oder Durchbrechen der Kohlenstoffnanoröhren in einzelne Bruchstücke bzw. Fragmente. Vorzugsweise haben die Fragmente eine Länge zwischen 30 nm und 100 nm. Dies erlaubt ein großes Aspektverhältnis, d. h. dass eine Länge typischerweise größer als ein Durchmesser eines der Kohlenstoffnanoröhren ist. In üblicher Weise haben einwandige Kohlenstoffnanoröhren einen Durchmesser zwischen 0,6 nm und 2 nm. Der Ultraschall wird typischerweise mit einer Leistung zwischen 30 W und 100 W und einer Frequenz zwischen 20 kHz und 40 kHz verwendet.

Die Fragmente können durch Anlegen eines elektrischen Feld auf der Oberfläche des Trägers ausgerichtet werden. Dies erlaubt in besonders einfacher Weise eine vertikale Ausrichtung, bei der die sich ausbildenden Kohlenstoffnanoröhren von der Oberfläche weggerichtet wachsen. Feldlinien des elektrischen Feld weisen hierzu vorzugsweise einen Winkel zwischen 80° und 100° zu der Oberfläche des Trägers auf, um eine vertikale Ausrichtung zu gewährleisten. Typischerweise haften die Kohlenstoffnanoröhren nach einem Trocknen der Dispersion an auf der Oberfläche zurückbleibenden Bestandteilen der Dispersion wie beispielsweise oberflächenaktiven Stoffen. Hierzu kann insbesondere das Substrat als eine Elektrode verwendet werden und das elektrische Feld zwischen dem Substrat und einer dem Substrat gegenüberliegenden Elektrode das Wachstum der Kohlenstoffnanoröhren entlang der Feldlinien unterstützen. Durch das elektrische Feld werden aber bereits auch die Fragmente während des Aufbringens auf das Substrat entsprechend ausgerichtet, so dass die Oberfläche von der Längsachse der Fragmente geschnitten wird und die Fragmente nicht parallel in einer Ebene zum Träger ausgerichtet sind.

Die Fragmente können durch Selbstorganisation auf einer auf der Oberfläche des Trägers aufgebrachten Goldschicht ausgerichtet werden. Hierzu werden vorzugsweise SH(CH₂)ₙNH₂-Moleküle, z. B. Cysteamine, verwendet, die für eine vertikale Ausrichtung der Kohlenstoffnanoröhren sorgen. Die beschriebene Selbstorganisation kann auch mit dem zuvor beschriebenen Ausrichten mittels des elektrischen Felds kombiniert werden.

Eine Oberflächendichte der Fragmente kann bei Aufbringen und Ausrichten der Fragmente kontrolliert werden über die Konzentration der Fragmente in der Dispersion, d. h. je höher der Anteil der Fragmente, desto größer ist auch die Oberflächendichte, also die Anzahl der Fragmente je Flächeneinheit. Die Fragmente können beispielsweise durch Eintauchen des Trägers in die Dispersion aufgebracht werden, wobei nachfolgend eine Trocknung des Trägers samt Beschichtung erfolgt, so dass die Fragmente letztlich auf einer trockenen Oberfläche haften.

Der Träger kann ein Siliziumoxid- oder Glassubstrat sein, da derartige Substrate in der Mikro- und Nanotechnologie oftmals verwendet werden, thermisch stabil bei Temperaturen bis 1200 °C und einfach zu handhaben sind.

Die Längsachse der auf dem Träger aufgebrachten Fragmente weist typischerweise einen Winkel zu der Oberfläche zwischen 60° und 120°, vorzugsweise zwischen 75° und 105°, besonders vorzugsweise zwischen 80° und 100° auf. Die Längsachse, entlang der die Kohlenstoffnanoröhren verlängert werden, steht also möglichst parallel zu einer Oberflächennormalen der Oberfläche des Trägers. Es kann auch nur ein bestimmter Prozentsatz der wachsenden Kohlenstoffnanoröhren diesen Winkel aufweisen, typischerweise 60 Prozent, vorzugsweise 75 Prozent, besonders vorzugsweise 90 Prozent. Der Träger selbst kann ein planarer Träger sein, d. h. die Oberfläche, auf der die Fragmente abgeschieden werden, ist eben.

Um die Kohlenstoffnanoröhren zu verlängern bzw. zu wachsen, kann plasmaunterstützte chemische Gasphasenabscheidung eingesetzt werden, da hierdurch ein verbessertes Wachstum erreicht wird.

Es kann vorgesehen sein, dass die Dispersion aus Wasser, vorzugsweise destilliertem Wasser, und einem oberflächenaktiven Stoff, vorzugsweise einem Tensid, gebildet wird, um eine homogene Dispersion zu erzeugen, die eine gleichmäßige Bedeckung der Oberfläche des Trägers ermöglicht. Als Tensid kann Natriumdodecylsulfat (sodium dodecyl sulfate, SDS) oder Natriumdodecylbenzolsulfonat (sodium dodecylbenzenesulfonate, SDBS) verwendet werden. Das Tensid dient vorzugsweise auch als Bindemittel und als Fixiermittel, insbesondere können getrocknete Reste des Tensids zum Binden und Fixieren der ausgerichteten Fragmente benutzt werden.

Typischerweise ist der oberflächenaktive Stoff in einer Konzentration von zwischen 0,02 Massenprozent und 2 Massenprozent, vorzugsweise weniger als 1 Massenprozent in der Dispersion vorhanden. Zusätzlich kann allerdings auch Isopropanol oder Ethanol zu der Dispersion aus destilliertem Wasser, dem oberflächenaktiven Stoff und der mindestens einen Kohlenstoffnanoröhre hinzugefügt werden.

Typischerweise bildet sich beim Trocknen der mit dem Tensiden versetzten Dispersion eine Tensidschicht auf dem Träger aus und die Fragmente der Kohlenstoffnanoröhren werden auf der Tensidschicht aufgebracht und ausgerichtet. Die Konzentration des Tensiden in der Dispersion wird hierbei derart gewählt, dass sich eine gewünschte Dicke der Tensidschicht einstellt, wobei bei einem höheren Anteil die Dicke der Tensidschicht pro Flächeneinheit ebenfalls erhöht wird.

Typischerweise werden nach dem Erzeugen der Fragmente Partikel aus der Dispersion entfernt, die keine Fragmente sind. Dies erfolgt vorzugsweise durch Ultrazentrifugation oder eine andere der bereits genannten Techniken. Hierdurch wird eine hohe Güte der abgeschiedenen Fragmente ohne störende Fremdkörper gewährleistet.

Die erzeugten Kohlenstoffnanoröhren mit gleichen elektronischen Eigenschaften können von dem Trägermaterial entfernt werden und als Ausgangsstoff für ein erneutes Durchführen des Verfahrens dienen. Hierdurch kann kaskadierend eine Ausbeute an Kohlenstoffnanoröhren mit gleichen elektronischen Eigenschaften erhöht werden. Dies erlaubt ein Aufskalieren des Verfahrens, wobei mit jedem Durchführen ein Reinheitsgrad, also ein Anteil an hergestellten Kohlenstoffnanoröhren mit identischen physikalischen Eigenschaften, systematisch erhöht werden kann.

Nach dem Wachsen durch chemische Gasphasenabscheidung können die vervielfältigten Kohlenstoffnanoröhren hinsichtlich ihrer Eigenschaften vermessen werden. Vorzugsweise erfolgt dies durch optische Absorptionsspektroskopie, Ramanspektroskopie und bzw. oder eine Photolumineszenzmessung. Kohlenstoffnanoröhren, die von den gewünschten Eigenschaften abweichen, werden danach von den restlichen Kohlenstoffnanoröhren mit gleichen elektronischen Eigenschaften getrennt. Die Trennung kann wiederum mittels Zentrifugieren, insbesondere Ultrazentrifugation, Chromatografie oder einer auf Gel oder Polymeren basierenden Technik erfolgen. Durch Zentrifugieren können in einem Verfahrensschritt auch Schmutzpartikel, die beim Erzeugen der Fragmente entstanden sind, aus der Dispersion entfernt werden, indem die Dispersion bei unterschiedlichen Beschleunigungen zentrifugiert wird.

Eine Packungsdichte der mit dem beschriebenen Verfahren hergestellten Kohlenstoffnanoröhren auf dem Träger kann bis zu 10000 pro µm², vorzugsweise bis zu 20000 Kohlenstoffnanoröhren pro µm² besonders vorzugsweise bis zu 40000 Kohlenstoffnanoröhren pro µm² betragen. Ein Abstand der Kohlenstoffnanoröhren zueinander auf dem Träger oder ein Abstand der Fragmente zueinander auf dem Träger ist typischerweise kleiner als 0,5 µm.

Auch wenn die Fragmente aus Kohlenstoffnanoröhren gebildet werden, können alternativ zu den Kohlenstoffnanoröhren an den Fragmenten auch Nanoröhren aus Bornitrid, Bor oder Silizium wachsen. Hierzu findet das Wachstum entsprechend in einer borhaltigen, siliziumhaltigen und bzw. oder stickstoffhaltigen Atmosphäre in der Vorrichtung zur chemischen Gasphasenabscheidung statt. Es ist auch möglich, dotierte Kohlenstoffnanoröhren zu wachsen, bei denen also an einzelnen Stellen von Kohlenstoffatomen verschiedene Atome in ein Gerüst der Nanoröhre eingefügt werden. Entsprechende Fremdatome werden hierbei während des Wachstums der Nanoröhren in der Vorrichtung zur chemischen Gasphasenabscheidung bereitgestellt.

Es ist ein Träger, typischerweise mit dem beschriebenen Verfahren, mit auf einer Oberfläche des Trägers angeordneten einwandigen Kohlenstoffnanoröhren gleichen Durchmessers und gleicher Chiralität herstellbar, bei dem die Kohlenstoffnanoröhren auf der Oberfläche derart angeordnet sind, dass eine Längsachse der Kohlenstoffnanoröhren die Oberfläche schneidet und die Kohlenstoffnanoröhren nicht parallel in einer Ebene zum Träger ausgerichtet sind und auf der Oberfläche eine getrocknete Tensidschicht mit einer Dicke, die geringer ist als eine Länge der Fragmente, aufgebracht ist, auf der die Fragmente der mindestens einen einwandigen Kohlenstoffnanoröhre aufgebracht und ausgerichtet sind. Es liegt somit ein Träger mit vertikal zu dem Träger ausgerichteten, auf dem Träger aufgebrachten Kohlenstoffnanoröhren vor, der in Bauteilen eingebaut werden kann.

Außerdem kann in einer vorteilhaften, allerdings nicht von der Erfindung umfassten Ausführungsform ein Träger mit darauf angeordneten und auf dem Träger ausgerichteten Fragmenten, aber noch nicht daran wachsenden oder bereits gewachsenen Kohlenstoffnanoröhren hergestellt werden, vorzugsweise mit dem beschriebenen Verfahren. Der Träger liegt somit typischerweise in dem Zustand vor, in dem er gemäß dem bereits beschriebenen Verfahren in die Vorrichtung zur chemischen Gasphasenabscheidung eingebracht wird. Ein derartig präparierter Träger kann gelagert und später weiterverarbeitet werden.

Es kann vorgesehen sein, dass auf dem Träger nach dem Trocknen eine aus der mit dem Tensiden versetzten Dispersion abgeschiedene Tensidschicht vorhanden ist. Auf dieser Tensidschicht sind die Fragmente angeordnet und deren Ausrichtung wird durch die Tensidschicht stabilisiert.

Diese Tensidschicht kann eine Dicke aufweisen, die geringer ist als eine Länge der Fragmente. Diese Dicke beträgt typischerweise zwischen 0,3 µm und 1 µm, vorzugsweise zwischen 0,5 µm und 0,8 µm. Hierdurch können die Fragmente einerseits zuverlässig an der Tensidschicht haften, ohne dass ein nachfolgendes Wachstum behindert wird.

Eine Oberfläche des Trägers, auf der die Fragmente ausgerichtet werden, kann nach dem Entfernen des Trägers aus der Dispersion und Trocknen des Trägers vollständig mit der Tensidschicht bedeckt sein, um auf einer möglichst großen Fläche ein Haften der Fragmente zu ermöglichen.

Statt des Tensiden kann die Oberfläche des Trägers auch mit einer Goldschicht versehen sein, auf der die Fragmente aufgebracht und ausgerichtet sind, wobei zum Ausrichten die Oberfläche vorzugsweise mit einer Schicht von SH(CH₂)ₙNH₂-Molekülen versehen ist.

Ausführungsbeispiele der Erfindung sind in den Zeichnungen dargestellt und werden nachfolgend anhand der Figuren 1 bis 8 erläutert.

Es zeigen:
- Fig. 1: eine in einem in perspektivischer Ansicht dargestellten Gefäß enthaltene Dispersion aus einer Flüssigkeit und einwandigen Kohlenstoffnanoröhren;
- Fig. 2: eine Ultraschallbehandlung der in Fig. 1 gezeigten Dispersion in einer Fig. 1 entsprechenden Ansicht;
- Fig. 3: die nach der in Fig. 2 gezeigten Ultraschallbehandlung erhaltenen Fragmente der Kohlenstoffnanoröhren in einer Fig. 1 entsprechenden Ansicht;
- Fig. 4: die aus der Dispersion auf eine Oberfläche eines Trägers abgeschiedenen Fragmente in einer perspektivischen Ansicht;
- Fig. 5: einen Reaktor zur chemischen Gasphasenabscheidung in einer perspektivischen Ansicht, in dem der in Fig. 4 dargestellte Träger eingebracht ist;
- Fig. 6: eine Fig. 4 entsprechende Ansicht des Trägers mit den verlängerten, vertikal ausgerichteten Kohlenstoffnanoröhren,
- Fig. 7: eine Mehrzahl der in Fig.6 dargestellten Träger mit darauf angeordneten Kohlenstoffnanoröhren und
- Fig. 8: eine Fig. 4 entsprechende Ansicht des Trägers mit einer Tensidschicht und darauf aufgebrachten Kohlenstoffnanoröhren.

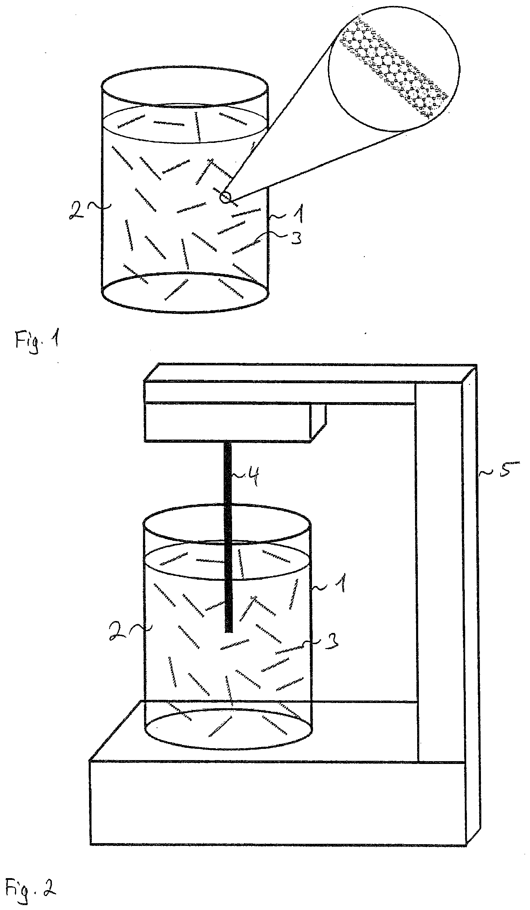

In Fig. 1 ist ein Gefäß 1 gezeigt, in dem eine homogene Dispersion 2 aus einer Flüssigkeit mit einem Tensiden und mehreren Kohlenstoffnanoröhren 3 enthalten ist. In weiteren Ausführungsbeispielen kann auch nur eine einzelne Kohlenstoffnanoröhre mit vorgegebenen elektronischen Eigenschaften als Ausgangsstoff für das Verfahren genommen werden. Die Flüssigkeit ist im dargestellten Ausführungsbeispiel destilliertes Wasser, es kann jedoch auch allgemein deionisiertes Wasser verwendet werden. Das Tensid, im dargestellten Ausführungsbeispiel Natriumdodecylsulfat, SDS, ist in einer Konzentration von 0,1 Massenprozent in der Dispersion vorhanden. Außerdem ist der Dispersion Isopropanol beigesetzt, worauf in weiteren Ausführungsbeispielen aber auch verzichtet werden kann. In einer vergrößerten Darstellung ist beispielhaft eine der Kohlenstoffnanoröhren 3 gezeigt. Mindestens 90 Prozent der in der Dispersion 2 enthaltenen Kohlenstoffnanoröhren 3 haben gleiche elektronische Eigenschaften, sind im dargestellten Ausführungsbeispiel also halbleitend, und haben vorzugsweise einen gleich großen Durchmesser und eine identische Chiralität. Außerdem sind die Kohlenstoffnanoröhren 3 alle einwandig. In weiteren Ausführungsbeispielen können die Kohlenstoffnanoröhren 3 aber auch metallisch sein. Durch die Zugabe des Tensiden wird vermieden, dass sich die Kohlenstoffnanoröhren 3 aneinander anlagern und Bündel bilden, sondern gleichverteilt in der Dispersion 2 vorhanden sind. In weiteren Ausführungsbeispielen können die Kohlenstoffnanoröhren 3 auch durch eine Säure oxidiert werden und somit statt hydrophob hydrophil sein oder es werden organische Lösungen wie Dimethylformamid (DMF) zum Erzeugen einer homogenen Dispersion verwendet. Die Kohlenstoffnanoröhren 3 mit identischen physikalischen Eigenschaften wurden im dargestellten Beispiel mit einem aus dem Stand der Technik bekannten Verfahren erzeugt und nachfolgend sortiert. In dem dargestellten Ausführungsbeispiel weisen 99 Prozent der für die Dispersion 2 verwendeten Kohlenstoffnanoröhren 3 identische Eigenschaften auf.

Um die in der Dispersion 2 enthaltenen Kohlenstoffnanoröhren 3 zu vervielfältigen bzw. zu reproduzieren, wird bei dem in Fig. 2 dargestellten Verfahrensschritt das Gefäß 1 mit der Dispersion 2 der Kohlenstoffnanoröhren 3 durch Ultraschalleinwirkung ein Brechen der Kohlenstoffnanoröhren 3 in kleinere Fragmente bewirkt. Wiederkehrende Merkmale sind in dieser Figur wie auch in den folgenden Figuren mit identischen Bezugszeichen versehen. Zum Erzeugen der Fragmente wird in die Dispersion 2 eine Spitze 4 eines Ultraschallsonikators eingebracht und Ultraschall einer Frequenz von 30 kHz und einer Leistung von 30 W bis 100 W über das Ultraschallgerät 5 in die Dispersion 2 eingebracht.

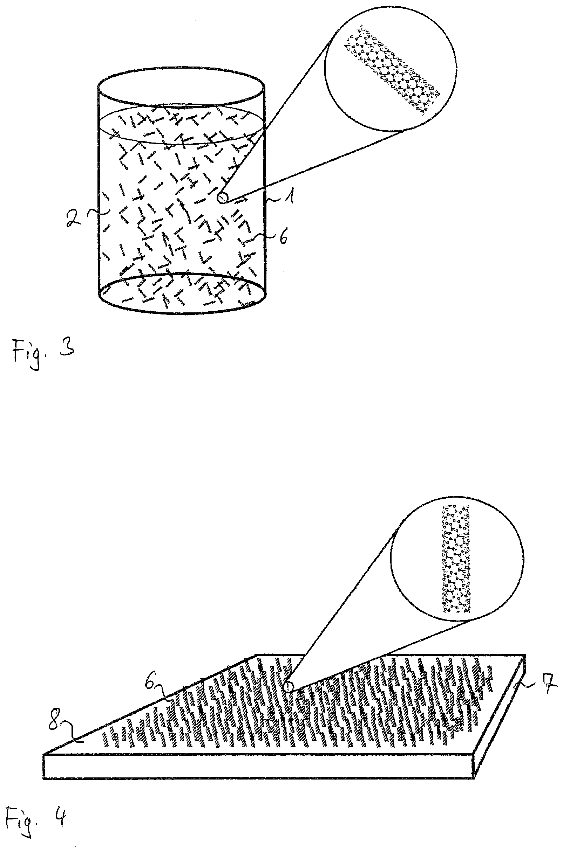

Das Gefäß 1 mit der Dispersion 2 und den erzeugten Fragmenten 6 ist in Fig. 3 dargestellt. Die Fragmente 6 weisen eine Länge von 30 nm bis 100 nm bei einem Durchmesser von ca. 1 nm auf. Da sich durch den Ultraschalleintrag auch weitere Partikel wie Bündel von Kohlenstoffnanoröhren 3, amorpher Kohlenstoff oder Reste von Katalysatoren gebildet haben können, können in einem weiteren Verfahrensschritt durch Zentrifugieren diese Partikel aus der Dispersion 2 entfernt werden, beispielsweise wird die Dispersion 2 acht Stunden lang bei einem 20000-fachen der Erdbeschleunigung, also 20000 g, zentrifugiert.

Die in Fig. 3 gezeigte Dispersion 2 wird auf einen planaren Träger 7 beispielsweise durch eine Pipette aufgebracht und die Flüssigkeit entfernt, beispielsweise durch Erhitzen. Der planare Träger 7 ist ein Siliziumwafer, der während oder nach dem Trocknen zum Entfernen flüssiger Bestandteile der Dispersion 2 in ein elektrisches Feld eingebracht wird und aufgrund seiner Temperaturbeständigkeit bis 1200 °C auch eine nachfolgende Weiterbehandlung unbeschadet übersteht. Feldlinien des elektrischen Feld stehen hierbei senkrecht auf eine ebene Oberfläche 8 des Trägers 7, so dass sich die Fragmente 6 parallel zu diesen Feldlinien auf der Oberfläche 8 ausrichten, also eine Längsachse der Fragmente 6 ebenfalls im rechten Winkel zu der Oberfläche 8 steht. Es ergibt sich somit eine Schicht vertikal auf dem Träger 7 ausgerichteter Fragmente 6. Es kann allerdings auch passieren, dass nur ein bestimmter Prozentsatz der Fragmente 6 eine gleiche Ausrichtung aufweist. Beispielsweise sind in dem dargestellten Ausführungsbeispiel 80 Prozent der Fragmente 6 parallel zu einer Oberflächennormale ausgerichtet, während der Rest einen Winkelversatz von bis zu 20° zu der Oberflächennormale aufweist.

In einem weiteren Ausführungsbeispiel ist auf die Oberfläche 8 eine Goldschicht flächig aufgebracht, auf der sich unterstützt durch Cysteamine, nämlich SH(CH₂)₂NH₂, die Fragmente 6 durch Selbstorganisation so ausrichten, dass die Längsachse die Oberfläche 8 schneidet, die Fragmente 6 also rechtwinklig auf der Oberfläche 8 stehen. Das Aufbringen der Dispersion 2 auf den Träger erfolgt durch Eintauchen des Trägers 7 in die Dispersion 2. Die verwendeten Cysteamine sind hierbei in der Dispersion 2 enthalten oder werden in einem vorhergehenden Verfahrensschritt auf die Goldschicht aufgebracht, beispielsweise durch Eintauchen in eine mit den Cysteaminen versetzte Flüssigkeit.

Der derartig präparierte Träger 7 mit den auf der Oberfläche 8 ausgerichteten Fragmenten 6 der einwandigen Kohlenstoffnanoröhren mit gleichen elektronischen Eigenschaften kann in dieser Form zwischengelagert werden und erst nachfolgend in einem weiteren Schritt weiterverarbeitet werden.

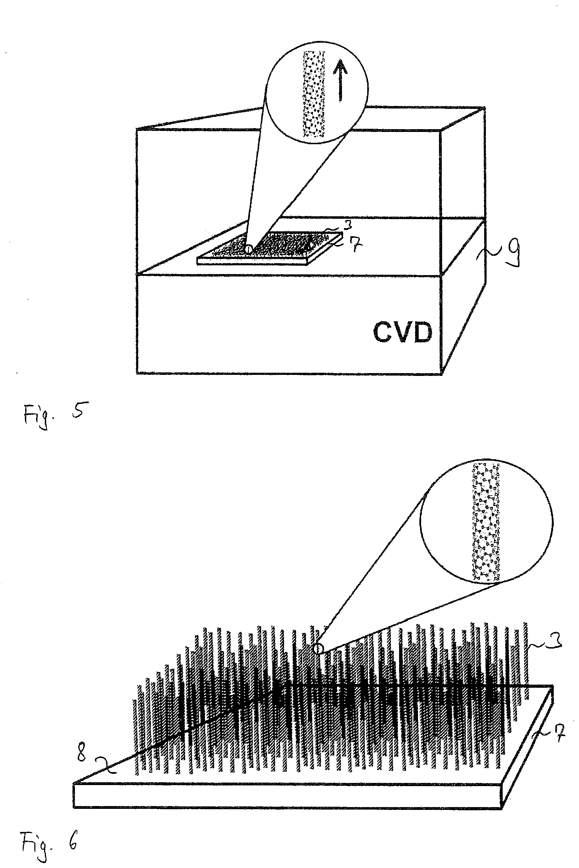

Der in Fig. 4 dargestellte Träger 7 mit auf der Oberfläche 8 ausgerichteten Fragmenten 6 der einwandigen Kohlenstoffnanoröhren 3 mit gleichen elektronischen Eigenschaften wird wie in Fig. 5 gezeigt in einen Reaktor 9 eingebracht, der zur chemischen Gasphasenabscheidung (chemical vapor deposition, CVD) geeignet ist. In diesem Reaktor 9 werden zunächst Spitzen der Fragmente 6 in einer wasserstoffhaltigen Atmosphäre chemisch aktiviert und danach werden in einer kohlenstoffhaltigen Atmosphäre startend von den Fragmenten 6 epitaktisch durch chemische Gasphasenabscheidung Kohlenstoffnanoröhren 3 mit gleichen elektronischen Eigenschaften und, sofern als Ausgangsstoff Kohlenstoffnanoröhren 3 mit gleichem Durchmesser und gleicher Chiralität verwendet wurden, auch mit gleichem Durchmesser und gleicher Chiralität gewachsen, bis die gewünschte Länge erreicht ist. In weiteren Ausführungsbeispielen kann hierfür auch plasmaunterstützte chemische Gasphasenabscheidung verwendet werden. Durch das epitaktische Wachstum wird die atomare Struktur der Fragmente 6, also insbesondere deren Durchmesser und deren Chiralität, nicht verändert. Außerdem können in entsprechender Atmosphäre auch dotierte Kohlenstoffnanoröhren, Bornitridnanoröhren, Bornanoröhren bzw. Siliziumnanoröhren gewachsen werden.

Nach dem Ende der chemischen Gasphasenabscheidung sind auf der Oberfläche 8 des Trägers 7 die Kohlenstoffnanoröhren 3 ausgehend von den als Startschicht verwendeten Fragmenten 6 gewachsen, wie in Fig. 6 gezeigt. Diese Kohlenstoffnanoröhren sind in dem dargestellten Ausführungsbeispiel einwandig, halbleitend und haben typischerweise jeweils einen gleichen Durchmessers und eine gleiche Chiralität, wenn als Ausgangsstoff Kohlenstoffnanoröhren mit gleichem Durchmesser und gleicher Chiralität verwendet wurden. Außerdem sind sie alle vertikal zur Oberfläche 8 angeordnet, d. h. entlang einer Längsachse der Fragmente 6 gewachsen und bilden eine Schicht vertikal angeordneter Kohlenstoffnanoröhren 3. Eine Packungsdichte beträgt im dargestellten Ausführungsbeispiel 10000 Kohlenstoffnanoröhren pro µm², während ein Abstand der Kohlenstoffnanoröhren zueinander kleiner als 0,5 µm ist.

Es kann in weiteren Ausführungsbeispielen vorgesehen sein, dass die gewachsenen Kohlenstoffnanoröhren 3 durch Ramanspektroskopie oder ein anderes Messverfahren hinsichtlich ihrer elektrischen und optischen Eigenschaften vermessen werden. Kohlenstoffnanoröhren 3, deren physikalische Eigenschaften sich von der Mehrheit unterscheiden, können anschließend aus dem Bündel der erhaltenen Kohlenstoffnanoröhren 3 entfernt werden, beispielsweise durch Ultrazentrifugation, Chromatografie oder ein auf Gelen oder Polymeren beruhendes Verfahren.

Die Kohlenstoffnanoröhren 3 können von dem Träger 7 entfernt werden und in Anwendungen, beispielsweise in Transistoren, beispielsweise Feldeffekttransistoren, oder anderen Bauteile wie Sensoren, Photonendetektoren, optischen Modulatoren, Lichtquellen Solarzellen oder thermoelektrischen Bauelementen eingebaut werden.

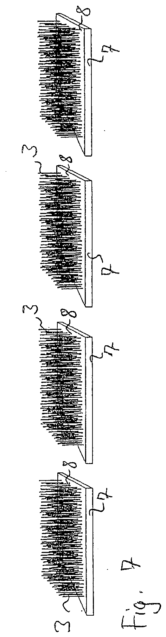

Alternativ können die Kohlenstoffnanoröhren 3 von dem Träger 7 entfernt werden und eine weitere Dispersion 2 gebildet werden, wie in Fig. 1 dargestellt. Das Verfahren kann dann zum kaskadierenden Vervielfältigen der Kohlenstoffnanoröhren 3 wiederholt werden, also ebenfalls durch Ultraschall Fragmente 6 erzeugt werden und diese Fragmente 6 auf einem weiteren Träger 7 abgeschieden und verlängert werden. Hierdurch ergibt sich die in Fig. 7 dargestellte Konfiguration von mehreren Trägern 7, auf denen jeweils Kohlenstoffnanoröhren 3 mit definierten physikalischen Eigenschaften abgeschieden sind.

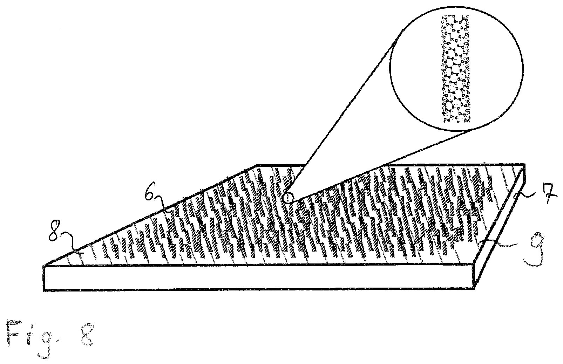

Fig. 8 zeigt in einer Figur 4 entsprechenden Ansicht den Träger 7 mit einer darauf abgeschiedenen, schraffiert eingezeichneten Tensidschicht 9 aus SDS, die eine Dicke von 200 nm aufweist und als Zwischenschicht eine Oberfläche 8 des Trägers 7, auf der die Fragmente 6 abgeschieden werden, vollständig, also ohne Aussparungen oder Löcher, bedeckt. Die Fragmente 6 weisen eine Länge auf, die größer ist als die Dicke der Tensidschicht 9, so dass die Fragmente 6 auf der Tensidschicht 9 abgeschieden und ausgerichtet sind und durch die getrocknete Tensidschicht 9 in ihrer Ausrichtung stabilisiert werden.

Lediglich in den Ausführungsbeispielen offenbarte Merkmale der verschiedenen Ausführungsformen können miteinander kombiniert und einzeln beansprucht werden.

## Patentansprüche

1. Verfahren zum Vervielfältigen von mindestens einer einwandigen Kohlenstoffnanoröhre (3) mit vorgegebenen elektronischen Eigenschaften oder mehreren einwandigen Kohlenstoffnanoröhren (3) mit gleichen elektronischen Eigenschaften, mit den Schritten:
a) Herstellen einer Dispersion (2) aus einer Flüssigkeit und der mindestens einen einwandigen Kohlenstoffnanoröhre (3) mit vorgegebenen elektronischen Eigenschaften oder den mehreren einwandigen Kohlenstoffnanoröhren (3) mit gleichen elektronischen Eigenschaften;
b) Ausbilden von Fragmenten (6) der mindestens einen einwandigen Kohlenstoffnanoröhre (3) oder der mehreren einwandigen Kohlenstoffnanoröhren (3) durch einen Energieeintrag in die Dispersion (2);
c) Aufbringen der Fragmente (6) der mindestens einen einwandigen Kohlenstoffnanoröhre (3) oder der mehreren einwandigen Kohlenstoffnanoröhren (3) aus der Dispersion (2) auf eine Oberfläche (8) eines Trägers (7) als Startschicht zum Vervielfältigen und Ausrichten der Fragmente (6) auf der Oberfläche (8) während des Aufbringens aus der Dispersion (2), so dass die Oberfläche (8) von einer Längsachse der Fragmente (6) geschnitten wird und die Fragmente (6) nicht parallel in einer Ebene zur Oberfläche (8) des Trägers (7) ausgerichtet sind, wobei die Fragmente (6) durch Selbstorganisation auf einer auf der Oberfläche (8) des Trägers (7) aufgebrachten Goldschicht ausgerichtet werden oder auf der Oberfläche (8) des Trägers (7) auf eine aus einem in der Dispersion (2) enthaltenen Tensid gebildete Tensidschicht (9) mit einer Dicke, die geringer ist als eine Länge der Fragmente, aufgebracht werden, auf der die Fragmente (6) der mindestens einen einwandigen Kohlenstoffnanoröhre nach dem Trocknen der Tensidschicht (9) aufgebracht und ausgerichtet sind sowie auf dem Träger (7) durch die Tensidschischt (9) fixiert werden;
d) Einbringen der auf dem Träger (7) aufgebrachten und ausgerichteten Fragmente (6) in eine Vorrichtung zur chemischen Gasphasenabscheidung (9), wobei in der Vorrichtung zur chemischen Gasphasenabscheidung (9) einwandige Kohlenstoffnanoröhren (3) mit gleichen elektronischen Eigenschaften ausgehend von den als Startschicht dienenden Fragmenten (6) in einer kohlenstoffhaltigen Gasatmosphäre mittels chemischer Gasphasenabscheidung verlängert werden.

2. Verfahren nach Anspruch 1, **dadurch gekennzeichnet, dass** die Fragmente (6) durch Einbringen von Ultraschall in die Dispersion (2) ausgebildet werden, wobei vorzugsweise Fragmente (6) mit einer Länge zwischen 30 nm und 100 nm erhalten werden, wobei besonders vorzugsweise Ultraschall mit einer Leistung von 30 W bis 100 W bei einer Frequenz zwischen 20 kHz und 40 kHz verwendet wird.

3. Verfahren nach einem der vorhergehenden Ansprüche, **dadurch gekennzeichnet, dass** die Fragmente (6) durch Anlegen eines elektrischen Felds auf der Oberfläche (8) ausgerichtet werden.

4. Verfahren nach einem der Ansprüche 1 bis 2, **dadurch gekennzeichnet, dass** zum Ausrichten der Fragmente (6) auf der auf dem Träger (7) aufgebrachten Goldschicht SH(CH₂)ₙNH₂-Moleküle verwendet werden.

5. Verfahren nach einem der vorhergehenden Ansprüche, **dadurch gekennzeichnet, dass** die Längsachse der aufgebrachten Fragmente (6) einen Winkel zu der Oberfläche zwischen 60° und 120°, vorzugsweise zwischen 75° und 105°, besonders vorzugsweise zwischen 80° und 100° aufweist, wobei der Träger (7) vorzugsweise ein Siliziumoxidsubstrat ist.

6. Verfahren nach einem der vorhergehenden Ansprüche, **dadurch gekennzeichnet, dass** plasmaunterstützte chemische Gasphasenabscheidung eingesetzt wird, um die Kohlenstoffnanoröhren (6) zu verlängern.

7. Verfahren nach einem der vorhergehenden Ansprüche, **dadurch gekennzeichnet, dass** die zum Vervielfältigen genutzten Kohlenstoffnanoröhren (3) einen gleichen Durchmesser und eine gleiche Chiralität aufweisen, und/oder die Dispersion (2) aus Wasser, vorzugsweise destilliertem Wasser, und einem oberflächenaktiven Stoff, vorzugsweise einem Tensid, zum Erzeugen einer homogenen Dispersion hergestellt wird.

8. Verfahren nach einem der vorhergehenden Ansprüche, **dadurch gekennzeichnet, dass** die erzeugten Kohlenstoffnanoröhren (3) mit gleichen elektronischen Eigenschaften von dem Träger (7) entfernt werden und das Verfahren mit diesen entfernten Kohlenstoffnanoröhren (3) zum weiteren Vervielfältigen der Kohlenstoffnanoröhren (3) erneut durchgeführt wird.

9. Verfahren nach einem der vorhergehenden Ansprüche, **dadurch gekennzeichnet, dass** die einwandigen Kohlenstoffnanoröhren mit einem Durchmesser zwischen 0,6 nm und 2 nm ausgebildet werden.

10. Verfahren nach einem der vorhergehenden Ansprüche, **dadurch gekennzeichnet, dass** nach dem Wachsen durch chemische Gasphasenabscheidung die vervielfältigten Kohlenstoffnanoröhren (3) hinsichtlich ihrer Eigenschaften vorzugsweise durch optische Absorptionsspektroskopie, Ramanspektroskopie und/oder eine Photolumineszenzmessung vermessen werden und Kohlenstoffnanoröhren (3), die von den gewünschten Eigenschaften abweichen, separiert werden.

11. Verfahren nach einem der vorhergehenden Ansprüche, **dadurch gekennzeichnet, dass** die Kohlenstoffnanoröhren (3) mit einer Packungsdichte von bis zu 10000 Kohlenstoffnanoröhren pro µm², vorzugsweise von bis zu 20000 Kohlenstoffnanoröhren pro µm² besonders vorzugsweise von bis zu 40000 Kohlenstoffnanoröhren pro µm² hergestellt werden, und/oder die Kohlenstoffnanoröhren (3) und/oder die Fragmente (6) der Kohlenstoffnanoröhren (3) auf dem Träger (7) mit einem Abstand von weniger als 0,5 µm zueinander angeordnet werden.

12. Träger (7) mit einer Oberfläche (8), auf der einwandige Kohlenstoffnanoröhren (3) mit gleichen elektronischen Eigenschaften derart aufgebracht sind, dass eine Längsachse der Kohlenstoffnanoröhren (3) die Oberfläche (8) schneidet und die Kohlenstoffnanoröhren (3) nicht parallel in einer Ebene zur Oberfläche (8) des Trägers (7) ausgerichtet sind und
auf der Oberfläche (8) eine getrocknete Tensidschicht (9) mit einer Dicke, die geringer ist als eine Länge der Fragmente (6), aufgebracht ist, auf der die Fragmente (6) der mindestens einen einwandigen Kohlenstoffnanoröhre (3) aufgebracht und ausgerichtet sind.

## Claims

1. A method of reproducing at least one single-walled carbon nanotube (3) having predefined electronic properties or a plurality of single-walled carbon nanotubes (3) having the same electronic properties, the method comprising the steps:
a) preparing a dispersion (2) from a liquid and from the at least one single-walled carbon nanotube (3) having predefined electronic properties or from the plurality of single-walled carbon nanotubes (3) having the same electronic properties;
b) forming fragments (6) of the at least one single-walled carbon nanotube (3) or of the plurality of single-walled carbon nanotubes (3) by an energy input into the dispersion (2);
c) applying the fragments (6) of the at least one single-walled carbon nanotube (3) or of the plurality of single-walled carbon nanotubes (3) from the dispersion (2) onto a surface (8) of a carrier (7) as a starting layer for reproducing and orienting the fragments (6) on the surface (8) during the application from the dispersion (2) so that the surface (8) is intersected by a longitudinal axis of the fragments (6) and the fragments (6) are not oriented in parallel in a plane with respect to the surface (8) of the carrier (7), wherein the fragments (6) are oriented by self-organization on a gold layer applied to the surface (8) of the carrier (7), or are applied to the surface (8) of the carrier (7) onto a surfactant layer (9) formed by a surfactant contained in the dispersion (2) and having a thickness that is less than a length of the fragments, on which the fragments (6) of the at least one single-walled carbon nanotube are applied and oriented after drying of the surfactant layer (9) and fixed to the carrier (7) by the surfactant layer (9);
d) introducing the fragments (6) applied to and oriented on the carrier (7) into an apparatus for chemical vapor deposition (9), with single-walled carbon nanotubes (3) having the same electronic properties being extended in the apparatus for chemical vapor deposition (9), starting from the fragments (6) serving as the starting layer, in a gas atmosphere containing carbon by means of chemical vapor deposition.

2. A method in accordance with claim 1, **characterized in that** the fragments (6) are formed by introduction of ultrasound into the dispersion (2), with fragments (6) having a length between 30 nm and 100 nm preferably being obtained, wherein particularly preferably ultrasound is used having a power of 30 W to 100 W at a frequency between 20 kHz and 40 kHz.

3. A method in accordance with one of the preceding claims, **characterized in that** the fragments (6) are oriented on the surface (8) by application of an electrical field.

4. A method in accordance with one of the preceding claims 1 to 2, **characterized in that** SH(CH₂)ₙNH₂ molecules are used for orienting the fragments (6) on the gold layer applied to carrier (7).

5. A method in accordance with one of the preceding claims, **characterized in that** the longitudinal axis of the applied fragments (6) has an angle with respect to the surface between 60° and 120°, preferably between 75° and 105°, particularly preferably between 80° and 100°, with the carrier (7) preferably being a silicon oxide substrate.

6. A method in accordance with one of the preceding claims, **characterized in that** plasma-assisted chemical vapor deposition is used to extend the carbon nanotubes (6).

7. A method in accordance with one of the preceding claims, **characterized in that** the carbon nanotubes (3) used for reproduction have the same diameter and the same chirality, and/or the dispersion (2) is prepared from water, preferably from distilled water, and from a surface-active substance, preferably a surfactant, for producing a homogeneous dispersion.

8. A method in accordance with one of the preceding claims, **characterized in that** the produced carbon nanotubes (3) having the same electronic properties are removed from the carrier (7) and the method is carried out again using these removed carbon nanotubes (3) for a further reproduction of the carbon nanotubes (3).

9. A method in accordance with one of the preceding claims, **characterized in that** the single-walled carbon nanotubes are formed with a diameter between 0.6 nm and 2 nm.

10. A method in accordance with one of the preceding claims, **characterized in that** the reproduced carbon nanotubes (3) are preferably measured with respect to their properties by optical absorption spectroscopy, Raman spectroscopy and/or a photoluminescence measurement after the growing by chemical vapor deposition and carbon nanotubes (3) differing from the desired properties are separated.

11. A method in accordance with one of the preceding claims, **characterized in that** the carbon nanotubes (3) are manufactured with a packing density of up to 10,000 carbon nanotubes per µm², preferably of up to 20.000 carbon nanotubes per µm², and particularly preferably of up to 40,000 carbon nanotubes per µm², and/or the carbon nanotubes (3) and/or the fragments (6) of the carbon nanotubes (3) are arranged on the carrier (7) with a spacing from one another of less than 0.5 µm.

12. A carrier (7) having a surface (8) on which single-walled carbon nanotubes (3) having the same electronic properties are applied such that a longitudinal axis of the carbon nanotubes (3) intersects the surface (8) and the carbon nanotubes (3) are not oriented in parallel in a plane with respect to the surface (8) of the carrier (7), and
a dried surfactant layer (9) with a thickness that is less than a length of the fragments (6), on which the fragments (6) of the at least one single-walled carbon nanotube (3) are applied and oriented, is applied to the surface (8).

## Revendications

1. Procédé pour la multiplication d'au moins un nanotube de carbone (3) à paroi unique avec des propriétés électroniques prédéterminées ou de plusieurs nanotubes de carbone (3) à paroi unique avec les mêmes propriétés électroniques, avec les étapes de :
a) fabrication d'une dispersion (2) à partir d'un liquide et du au moins un nanotube de carbone (3) à paroi unique avec des propriétés électroniques prédéterminées ou des plusieurs nanotubes de carbone (3) à paroi unique avec les mêmes propriétés électroniques ;
b) formation de fragments (6) du au moins un nanotube de carbone (3) à paroi unique ou des plusieurs nanotubes de carbone (3) à paroi unique par un apport d'énergie dans la dispersion (2) ;
c) dépôt des fragments (6) du au moins un nanotube de carbone (3) à paroi unique ou des plusieurs nanotubes de carbone (3) à paroi unique à partir de la dispersion (2) sur une surface (8) d'un support (7) en tant que couche de départ pour multiplier et orienter les fragments (6) sur la surface (8) pendant le dépôt à partir de la dispersion (2), de sorte que la surface (8) est coupée par un axe longitudinal des fragments (6) et les fragments (6) ne sont pas orientés parallèlement dans un plan à la surface (8) du support (7), dans lequel les fragments (6) sont orientés par auto-organisation sur une couche d'or déposée sur la surface (8) du support (7) ou sont déposés sur la surface (8) du support (7) sur une couche de tensioactif (9) formée d'un tensioactif contenu dans la dispersion (2) avec une épaisseur qui est inférieure à une longueur des fragments (6), sur laquelle les fragments du au moins un nanotube de carbone à paroi unique sont déposés et orientés après le séchage de la couche de tensioactif (9) et sont fixés sur le support (7) par la couche de tensioactif (9) ;
d) introduction des fragments (6) déposés et orientés sur le support (7) dans un dispositif de dépôt chimique en phase vapeur (9), dans lequel des nanotubes de carbone (3) à paroi unique avec les mêmes propriétés électroniques sont allongés au moyen d'un dépôt chimique en phase vapeur (9) dans une atmosphère gazeuse contenant du carbone, à partir des fragments (6) servant de couche de départ.

2. Procédé selon la revendication 1, **caractérisé en ce que** les fragments (6) sont formés par introduction d'ultrasons dans la dispersion (2), dans lequel de préférence des fragments (6) avec une longueur comprise entre 30 nm et 100 nm sont obtenus, dans lequel de manière particulièrement préférée des ultrasons avec une puissance de 30 W à 100 W à une fréquence comprise entre 20 kHz et 40 kHz sont utilisés.

3. Procédé selon l'une quelconque des revendications précédentes, **caractérisé en ce que** les fragments (6) sont orientés par application d'un champ électrique sur la surface (8).

4. Procédé selon l'une quelconque des revendications 1 à 2, **caractérisé en ce que** des molécules SH(CH₂)ₙNH₂ sont utilisées pour orienter les fragments (6) sur la couche d'or déposée sur le support (7).

5. Procédé selon l'une quelconque des revendications précédentes, **caractérisé en ce que** l'axe longitudinal des fragments (6) déposés présente un angle par rapport à la surface compris entre 60° et 120°, de préférence entre 75° et 105°, plus préférentiellement entre 80° et 100°, dans lequel le support (7) est de préférence un substrat d'oxyde de silicium.

6. Procédé selon l'une quelconque des revendications précédentes, **caractérisé en ce que** le dépôt chimique en phase vapeur assisté par plasma est utilisé pour allonger les nanotubes de carbone (6).

7. Procédé selon l'une quelconque des revendications précédentes, **caractérisé en ce que** les nanotubes de carbone (3) utilisés pour la multiplication ont un même diamètre et une même chiralité, et/ou la dispersion (2) est préparée à partir d'eau, de préférence de l'eau distillée, et d'une substance tensioactive, de préférence un tensioactif, pour produire une dispersion homogène.

8. Procédé selon l'une quelconque des revendications précédentes, **caractérisé en ce que** les nanotubes de carbone (3) produits avec les mêmes propriétés électroniques sont retirés du support (7) et le procédé est à nouveau mis en oeuvre avec ces nanotubes de carbone (3) retirés pour multiplier davantage les nanotubes de carbone (3).

9. Procédé selon l'une quelconque des revendications précédentes, **caractérisé en ce que** les nanotubes de carbone à paroi unique sont réalisés avec un diamètre compris entre 0,6 nm et 2 nm.

10. Procédé selon l'une quelconque des revendications précédentes, **caractérisé en ce qu'**après la croissance par dépôt chimique en phase vapeur, les nanotubes de carbone (3) multipliés sont mesurés quant à leurs propriétés, de préférence par spectroscopie d'absorption optique, spectroscopie Raman et/ou une mesure de photoluminescence, et les nanotubes de carbone (3), qui s'écartent des propriétés souhaitées, sont séparés.

11. Procédé selon l'une quelconque des revendications précédentes, **caractérisé en ce que** les nanotubes de carbone (3) sont fabriqués avec une densité de tassement allant jusqu'à 10 000 nanotubes de carbone par µm², de préférence jusqu'à 20000 nanotubes de carbone par µm², de préférence jusqu'à 40 000 nanotubes de carbone par µm² et/ou les nanotubes de carbone (3) et/ou les fragments (6) des nanotubes de carbone (3) sont disposés sur le support (7) à une distance inférieure à 0,5 µm les uns des autres.

12. Support (7) avec une surface (8) sur laquelle sont déposés des nanotubes de carbone (3) à paroi unique avec les mêmes propriétés électroniques, de telle sorte qu'un axe longitudinal des nanotubes de carbone (3) coupe la surface (8) et les nanotubes de carbone (3) ne sont pas orientés parallèlement dans un plan à la surface (8) du support (7) et
une couche de tensioactif (9) séchée avec une épaisseur qui est inférieure à une longueur des fragments (6) est déposée sur la surface (8), sur laquelle les fragments (6) du au moins un nanotube de carbone (3) à paroi unique sont déposés et orientés.
